# EUROPEAN PATENT APPLICATION

(11) **EP 4 160 280 A1**
(43) Date of publication of application: **05.04.2023**
(21) Application number: 22192137.2
(22) Date of filing: 25.08.2022
(51) Int. Cl.: G02B 5/28, H01L 27/146, H04N 23/84, H04N 25/13, G01J 3/26

(54) **SPECTRAL FILTER, AND IMAGE SENSOR AND ELECTRONIC DEVICE INCLUDING THE SPECTRAL FILTER**

(30) Priority: 30.09.2021 KR 20210130289; 13.04.2022 KR 20220045809
(71) Applicant: Samsung Electronics Co., Ltd., Gyeonggi-do, 16677 (KR)
(72) Inventor: Kim, Hyochul, Gyeonggi-do (KR); Roh, Younggeun, Gyeonggi-do (KR); Lee, Jaesoong, Gyeonggi-do (KR)
(74) Representative: Grünecker Patent- und Rechtsanwälte PartG mbB

(57) **Abstract**

Provided are a spectral filter, and an image sensor and an electronic device including the spectral filter. The spectral filter includes: a first metal reflective layer; a second metal reflective layer provided above the first metal reflective layer; a plurality of cavities provided between the first and second metal reflective layers, the plurality of cavities including first patterns corresponding to different center wavelengths; and a plurality of lower pattern films provided below the first metal reflective layers, the plurality of lower pattern films including second patterns corresponding to the different center wavelengths.

## Description

### BACKGROUND

### 1. Field

The present disclosure relates to a spectral filter, and an image sensor and an electronic device including the spectral filter.

### 2. Description of the Related Art

In the related art, an image sensor divides a wavelength band into only three sections of red (R), green (G), and blue (B). For improvement in the accuracy of color expression and a performance of object recognition, there is requirement for development of an image sensor including a spectral filter which divides a wavelength band into more than three sections. However, a spectral filter in the related art is used for a dedicated camera including large and complex optical elements, and a technology of a module of an image sensor in which a spectral filter is integrated with a semiconductor chip is still being researched and developed.

### SUMMARY

Example embodiments of the disclosure provide a spectral filter, and an image sensor and an electronic device including the spectral filter.

Additional aspects will be set forth in part in the description which follows and, in part, will be apparent from the description, or may be learned by practice of the presented embodiments of the disclosure.

According to an aspect of an example embodiment, a spectral filter includes: a first metal reflective layer; a second metal reflective layer provided above the first metal reflective layer; a plurality of cavities provided between the first and second metal reflective layers, the plurality of cavities including first patterns respectively corresponding to different center wavelengths; and a plurality of lower pattern films being provided below the first metal reflective layer, the plurality of lower pattern films including second patterns respectively corresponding to the different center wavelengths.

The plurality of cavities may have a same thickness, and the plurality of lower pattern films may have a same thickness.

Each of the plurality of cavities may have a thickness of from about 50 nm to about 400 nm. Each of the plurality of lower pattern films may have a thickness of from about 100 nm to about 1,000 nm.

The spectral filter may further include a spacer provided between at least one of the plurality of cavities and the second metal reflective layer, the spacer including a dielectric material.

The spacer may have a thickness of from about 20 nm to about 300 nm.

A planarization layer may be provided on the second metal reflective layer on which the spacer is not provided.

Each of the plurality of cavities may include: a first dielectric material; and a second dielectric material having a refractive index different from that of the first dielectric, the first dielectric material and the second dielectric material forming a first pattern. Each of the plurality of cavities may further include an etch stop layer.

Each of the plurality of lower pattern films may include: a third dielectric material; and a fourth dielectric material having a refractive index different from that of the third dielectric material, the third dielectric material and the fourth dielectric material forming a second pattern. Each of the plurality of lower pattern films may further include an etch stop layer.

The first and second metal reflective layers may include a same metal material.

The first and second metal reflective layers may each include Al, Ag, Au, Cu, Ti, W, or TiN. At least one of the first and second metal reflective layers may further include poly-Si.

The first and second metal reflective layers may have a thickness from about 10 nm to about 80 nm.

The spectral filter may further include a plurality of upper films provided on the second metal reflective layer, the plurality of upper films having different thicknesses respectively corresponding to the different center wavelengths.

The spectral filter may further include a plurality of upper pattern films provided on the second metal reflective layer, the plurality of upper pattern films including third patterns respectively corresponding to the different center wavelengths.

Each of the upper pattern films may have a thickness of from about 100 nm to about 1,000 nm.

Each of the upper pattern films may include: a fifth dielectric material; and a sixth dielectric material having a refractive index different from that of the fifth dielectric material, the fifth dielectric material and the sixth dielectric material forming a third pattern. Each of the upper pattern films may further include an etch stop layer.

The spectral filter may further include a plurality of microlenses or a plurality of nanopatterns provided on the second metal reflective layer.

The spectral filter may further include an additional filter provided on the second metal reflective layer and only transmitting light in a certain wavelength band.

The additional filter may include a color filter or a broadband filter.

A short wavelength absorption filter may be provided in a portion of the second metal reflective layer, and a long wavelength cut-off filter may be provided in another portion of the second metal reflective layer.

According to an aspect of another embodiment, an image sensor includes:
a pixel array including a plurality of pixels;
and a spectral filter provided in the pixel array,
wherein the spectral filter includes:
   a first metal reflective layer;
   a second metal reflective layer provided above the first metal reflective layer;
   a plurality of cavities provided between the first and second metal reflective layers, the plurality of cavities including first patterns respectively corresponding to different center wavelengths; and
   a plurality of lower pattern films provided between the first metal reflective layer and the pixel array, the plurality of lower pattern films including second patterns respectively corresponding to the different center wavelengths.

The pixel array may include a plurality of pixels, and each of the plurality of pixels may include a wiring layer, in which a driving circuit is provided, and a photodiode provided in the wiring layer.

The plurality of cavities may have a same thickness, and the plurality of lower pattern films may have a same thickness.

Each of the plurality of cavities may have a thickness of from about 50 nm to about 400 nm, and each of the plurality of lower pattern films may have a thickness of from about 100 nm to about 1,000 nm.

The spectral filter may further include a spacer provided between at least one of the plurality of cavities and the second metal reflective layer, the spacer including a dielectric material.

The spacer may have a thickness of from about 20 nm to about 300 nm.

The first and second metal reflective layers may include a same metal material.

The spectral filter may further include a plurality of upper films provided on the second metal reflective layer, the plurality of upper films having different thicknesses respectively corresponding to the different center wavelengths.

The spectral filter may further include a plurality of upper pattern films provided on the second metal reflective layer, the plurality of upper pattern films including third patterns respectively corresponding to the different center wavelengths.

The spectral filter may further include a plurality of microlenses or a plurality of nanopatterns provided on the second metal reflective layer.

The spectral filter may further include an additional filter provided on the second metal reflective layer and only transmitting light in a certain wavelength band.

The image sensor may further include a timing controller, a row decoder, and an output circuit.

According to an aspect of an example embodiment, an electronic device includes an image sensor. The image sensor includes a pixel array including a plurality of pixels; and a spectral filter arranged in the pixel array. The spectral filter includes: a first metal reflective layer; a second metal reflective layer provided above the first metal reflective layer; a plurality of cavities provided between the first metal reflective layer and the second metal reflective layer, the plurality of cavities including first patterns respectively corresponding to different center wavelengths; and a plurality of lower pattern films provided between the first metal reflective layer and the pixel array, the plurality of lower pattern films including second patterns corresponding to the different center wavelengths.

The electronic device may include a mobile phone, a smartphone, a tablet, a smart tablet, a digital camera, a camcorder, a notebook computer, a television, a smart television, a smart refrigerator, a security camera, a robot, or a medical camera.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic cross-sectional view of an image sensor according to an example embodiment;
FIG. 2 is a schematic cross-sectional view of a spectral filter according to an embodiment;
FIG. 3A shows an example of a first pattern applicable to each cavity shown in FIG. 2;
FIG. 3B shows another example of a first pattern applicable to each cavity shown in FIG. 2;
FIG. 4 is a spectral filter according to another example embodiment;
FIG. 5 is a spectral filter according to another example embodiment;
FIG. 6 shows an example of sixteen unit filters arranged in the form of a 4x4 array applied to the spectral filter of FIG. 5;
FIG. 7A shows transmittance spectrums of first to eighth unit filters shown in FIG. 6;
FIG. 7B shows transmittance spectrums of ninth to sixteenth unit filters shown in FIG. 6;
FIG. 8 shows transmittance spectrums of the first to sixteenth unit filters shown in FIG. 6;
FIG. 9 shows a spectral filter according to another example embodiment;
FIG. 10 shows a spectral filter according to another example embodiment;
FIG. 11 shows a spectral filter according to another example embodiment;
FIG. 12 shows a spectral filter according to another example embodiment;
FIG. 13 shows a spectral filter according to another example embodiment;
FIG. 14 is a schematic cross-sectional view of a broadband filter that is usable as an additional filter of FIG. 13, according to an embodiment;
FIG. 15 is a schematic cross-sectional view of a broadband filter that is usable as the additional filter of FIG. 13, according to another embodiment;
FIG. 16 is a cross-sectional view of a spectral filter according to another embodiment;
FIG. 17 is a block diagram of an image sensor according to an example embodiment;
FIG. 18 is a top-plan view of an example of a spectral filter that is applicable to the image sensor of FIG. 17;
FIG. 19 is a top-plan view of another example of a spectral filter that is applicable to the image sensor of FIG. 17;
FIG. 20 is a top-plan view of another example of a spectral filter that is applicable to the image sensor of FIG. 17;
FIG. 21 is a schematic block diagram of an electronic device including an image sensor according to example embodiments;
FIG. 22 is a schematic block diagram of a cameral module shown in FIG. 21; and
FIGS. 23 to 24 are schematic diagrams of various examples of an electronic device, to which image sensors according to example embodiments are applied.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

In the drawings, the size of each constituent element illustrated in the drawings may be exaggerated for convenience of explanation and clarity. In the following descriptions, while certain embodiments will be described, these are merely examples, and those skilled in the art to which the disclosure pertains would understand that various modifications and changes can be made without departing from the spirit and scope of the disclosure.

When a constituent element is disposed "above" or "on" to another constituent element, the constituent element may include not only an element directly contacting on the upper/lower/left/right sides of the other constituent element, but also an element disposed above/under/left/right the other constituent element in a noncontact manner. As used herein, the singular forms "a", "an" and "the" are intended to include the plural forms as well, unless the context clearly indicates otherwise. It will be further understood that the terms "comprises" and/or "comprising" used herein specify the presence of stated features or components, but do not preclude the presence or addition of one or more other features or components.

The use of the terms "a" and "an" and "the" and similar referents in the context of describing the disclosure are to be construed to cover both the singular and the plural. Also, the steps of all methods described herein may be performed in any suitable order unless otherwise indicated herein or otherwise clearly contradicted by context. The disclosure is not limited to the described order of the steps.

Furthermore, terms such as "to portion", "to unit", "to module", and "to block" stated in the specification may signify a unit to process at least one function or operation, and the unit may be embodied by hardware, software, or a combination of hardware and software.

Furthermore, the connecting lines, or connectors shown in the various figures presented are intended to represent functional relationships and/or physical or logical couplings between the various elements.

The use of any and all examples, or language (e.g., "such as") provided herein, is intended merely to better illuminate the disclosure and does not pose a limitation on the scope of the disclosure unless otherwise claimed.

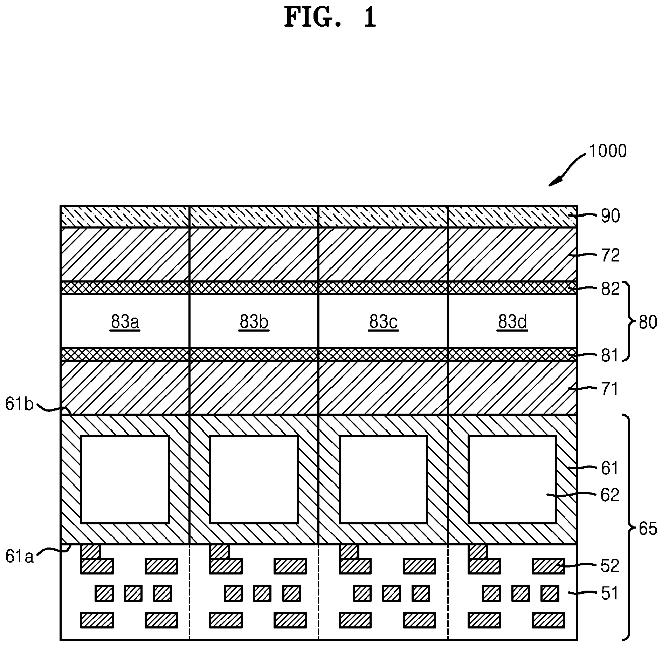

FIG. 1 is a schematic cross-sectional view of an image sensor 1000 according to an example embodiment. The image sensor 1000 shown in FIG. 1 may include, for example, a complementary metal oxide semiconductor (CMOS) image sensor or a charged coupled device (CCD) image sensor.

Referring to FIG. 1, the image sensor 1000 may include a pixel array 65 and a resonator structure 80 provided above the pixel array 65. Here, the pixel array 65 may include a plurality of pixels arranged in two dimensions, and the resonator structure 80 may include a plurality of resonators provided to correspond to the plurality of pixels. FIG. 1 illustrates an example in which the pixel array 65 includes four pixels and the resonator structure 80 includes four resonators.

Each pixel in the pixel array 65 may include a photodiode 62, which is a photoelectric transformation element, and a driving circuit 52 configured to drive the photodiode 62. The photodiode 62 may be buried in a semiconductor substrate 61, which has two surfaces 61a, 61b that face each other. A silicon substrate, for example, may be used as the semiconductor substrate 61. However, the embodiment is not limited thereto. A wiring layer 51 may be provided on or under the semiconductor substrate 61, and for example, the driving circuit 52 such as a metal oxide semiconductor field effect transistor (MOSFET) may be provided in the wiring layer 51.

The resonator structure 80 including the plurality of resonators is provided above the semiconductor substrate 61. The resonators may be provided to respectively transmit light of desired specific wavelength ranges. The plurality of resonators may include a first reflective layer 81 and a second reflective layer 82, which are provided apart from each other, and cavities 83a, 83b, 83c, and 83d provided between the first reflective layer 81 and the second reflective layer 82. Each of the first reflective layer 81 and second reflective layer 82 may include, for example, a metal reflective layer or a Bragg reflective layer. Each of the cavities 83a, 83b, 83c, and 83d may be provided to resonate light of desired specific wavelength ranges.

A first function layer 71 may be provided between a top surface of the semiconductor substrate 61 and the resonator structure 80. The first function layer 71 may be configured to, for example, improve a transmittance of light that is transmitted through the resonator structure 80 and incident to the photodiode 62. To this end, the first function layer 71 may have a dielectric layer or a dielectric pattern having an adjusted transmittance.

A second function layer 72 may be provided above the resonator structure 80. The second function layer 72 may be configured to, for example, improve a transmittance of light incident to the resonator structure 80. To this end, the second function layer 72 may include a dielectric layer or a dielectric pattern having an adjusted transmittance. A third function layer 90 may be further provided above the second function layer 72. The third function layer 90 may include, for example, an antireflection layer, a condenser lens, a color filter, a short wavelength absorption filter, a long wavelength absorption filter, or the like. However, this is merely an example.

At least one of the first function layer 71, the second function layer 72, and the third function layer 90 described above, together with the resonator structure 80, may configure a spectral filter to be described later. Hereinafter, a spectral filter according to an example embodiment will be described in detail.

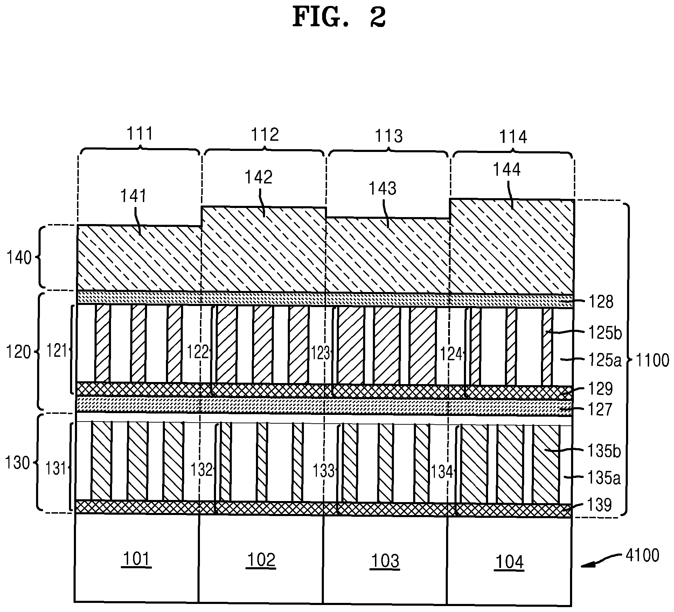

In the following description, a spectral filter 1100 of the image sensor 1000 is described in detail. FIG. 2 is a cross-sectional view of the spectral filter 1100 according to an example embodiment.

Referring to FIGS. 1 and 2, the spectral filter 1100 may include a plurality of unit filters (e.g., a first unit filter 111, a second unit filter 112, a third unit filter 113, and a fourth unit filter 114) arranged in two dimensions on a plan view of the spectral filter 1100. A pixel array 4100 including a plurality of pixels (e.g., a first pixel 101, a second pixel 102, a third pixel 103, and a fourth pixel 104) respectively corresponding to the plurality of unit filters 111, 112, 113 and 114 may be provided on or below the spectral filter 1100. FIG. 2 illustrates an example of first to fourth filters 111 to 114 and first to fourth pixels 101 to 104. The first to fourth filters 111 to 114 may respectively have different center wavelengths.

The spectral filter 1100 may include a resonance layer 120 including a plurality of resonators. The resonance layer 120 may include first and second metal reflective layers 127 and 128 provided apart from each other, and a plurality of cavities (e.g., a first cavity 121, a second cavity 122, a third cavity 123, and a fourth cavity 124) provided between the first and second metal reflective layers 127 and 128. The first and second metal reflective layers 127 and 128 may include a lower metal reflective layer and an upper metal reflective layer, respectively. FIG. 2 illustrates an example of first to fourth resonators and the first to fourth cavities 121 to 124.

A first resonator may include the first metal reflective layer 127, the second metal reflective layer 128, and the first cavity 121 provided between the first and second metal reflective layers 127 and 128; and a second resonator may include the first metal reflective layer 127, the second metal reflective layer 128, and the second cavity 122 provided between the first and second metal reflective layers 127 and 128. A third resonator may include the first metal reflective layer 127, the second metal reflective layer 128, and the third cavity 123 provided between the first and second metal reflective layers 127 and 128; and a fourth resonator may include the first metal reflective layer 127, the second metal reflective layer 128, and the fourth cavity 124 provided between the first and second metal reflective layers 127 and 128. Here, the first to fourth resonators may respectively have different center wavelengths (for example, first to four center wavelengths).

Each of the resonators may have a Fabry-Perot structure. When light is incident on each of the cavities 121, 122, 123, and 124 by transmitting through the second metal reflective layer 128, the light may reciprocate between the first metal reflective layer 127 and the second metal reflective layer 128 inside the cavities 121, 122, 123, and 124, during which a constructive interference and a destructive interference occur. Light having specific center wavelengths and satisfying a constructive interference condition in each of the cavities 121 to 124 may be incident on each of the pixels 101 to 104 of the pixel array 4100 by transmitting through the first metal reflective layer 127.

The first metal reflective layer 127 and the second metal reflective layer 128 may each include a metal material capable of reflecting light in a certain wavelength range. For example, the first metal reflective layer 127 and the second metal reflective layer 128 may each include aluminum (Al), silver (Ag), gold (Au), copper (Cu), titanium (T), tungsten (W), or titanium nitride (TiN). However, this is merely an example. At least one of the first metal reflective layer 127 and the second metal reflective layer 128 may further include poly-Si. The first metal reflective layer 127 and the second metal reflective layer 128 may include a same metal material. However, the first and second metal reflective layers 127 and 128 are not limited thereto and may include different metal materials, respectively, than the above mentioned examples. The first metal reflective layer 127 and the second metal reflective layer 128 may each have a thickness of about tens of nanometers. For example, the first metal reflective layer 127 and the second metal reflective layer 128 may have a thickness from about 10 nm to about 80 nm. As a detailed example, each of the first and second metal reflective layers 127 and 128 may have a thickness of from about 10 nm to about 50 nm. However, the thickness of each of the first and second metal reflective layers 127 and 128 is not limited thereto.

The first to fourth cavities 121 to 124 are provided between the first metal reflective layer 127 and the second metal reflective layer 128. Each of the first to fourth cavities 121 to 124 may have a multi-mode structure having a plurality of center wavelengths. In this case, a center wavelength of a first order mode of each of the first to fourth cavities 121 to 124 may be used as a center wavelength of each resonator. However, the embodiment is not necessarily limited thereto, and each of the first to fourth cavities 121 to 124 may have a single-mode structure having a single center wavelength.

The first to fourth cavities 121 to 124 may have different center wavelengths by adjusting effective refractive indexes. To this end, the first to fourth cavities 121 to 124 may include different first patterns respectively corresponding to the different center wavelengths. For example, the first cavity 121 may include a first pattern corresponding to a first center wavelength, and the second cavity 122 may include a first pattern corresponding to a second center wavelength. The third cavity 123 may have a first pattern corresponding to a third center wavelength, and the fourth cavity 124 may have a first pattern corresponding to a fourth center wavelength.

Each of the first to fourth cavities 121 to 124 may include a first dielectric material 125a, and second dielectric materials 125b arranged at intervals in the first dielectric material 125a to form the first pattern. Here, the second dielectric materials 125b may have a refractive index different from that of the first dielectric material 125a. Each of the first and second dielectric materials 125a and 125b may include, for example, silicon, silicon oxide, silicon nitride, titanium oxide, or the like. In a detailed example, the first dielectric material 125a may include silicon oxide, and the second dielectric materials 125b may include titanium oxide. However, this is merely an example.

FIG. 2 illustrates an example in which the second dielectric material 125b is connected to the first metal reflective layer 127 and the second metal reflective layer 128 through, for example, a Damascene process. However, the embodiment is not limited thereto, and the second dielectric material 125b may have a mesa structure that is not connected to the second metal reflective layer 128.

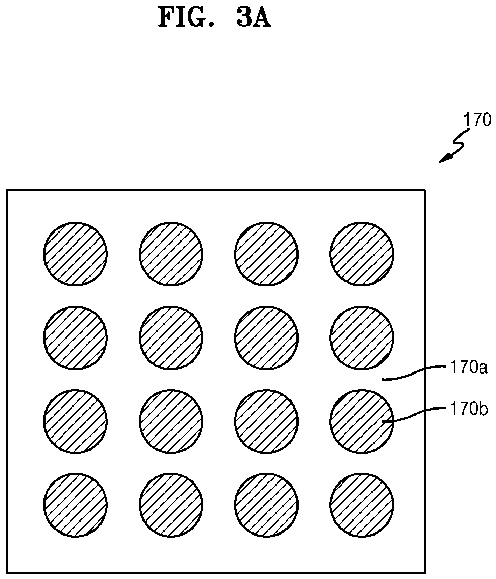

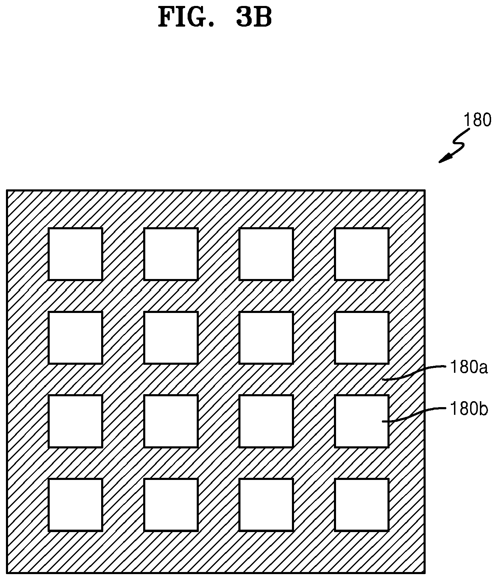

FIGS. 3A and 3B show examples of the first patterns that are applicable to the first to fourth cavities 121 to 124. Referring to FIG. 3A, in a first pattern 170 according to an embodiment, second dielectric materials 170b having a refractive index greater than that of a first dielectric material 170a are arranged in the form of a two-dimensional array in the first dielectric material 170a. Although FIG. 3A illustrates a case where each of the second dielectric materials 170b has a circular cross-section, each of the second dielectric materials 170b may have a cross-section with various shapes other than a circle. Referring to FIG. 3B, in a first pattern 180 according to another example, second dielectric materials 180b having a refractive index less than that of a first dielectric material 180a are arranged in the form of a two-dimensional array in the first dielectric material 180a. FIG. 3B illustrates a case where each of the second dielectric materials 180b has a square cross-section, and each of the second dielectric materials 180b may have a cross-section with various shapes other than a square.

Referring to FIG. 2, the first patterns may be differently formed by changing a size and/or shape of the second dielectric materials 125b arranged at intervals in the first dielectric material 125a, and accordingly, the plurality of cavities 121 to 124 with different center wavelengths may be formed by changing an effective refractive index.

An etch stop layer 129 may be further provided on or below the first and second dielectric materials 125a and 125b. The etch stop layer 129 is to further facilitate a patterning process for forming cavities. The etch stop layer 129 may include, for example, silicon, oxide, titanium oxide, hafnium oxide, or the like, but is not limited thereto. The etch stop layer 129 may include a material having an etching rate that is equal to or less than half (for example, equal to or less than one-fifth) an etching rate of a dielectric material included in the cavities 121 to 124. For example, when the cavities 121 to 124 include silicon oxide, the etch stop layer 129 may include hafnium oxide.

As described above, the first to fourth cavities 121 to 124 may be formed to have different first patterns respectively corresponding to the center wavelengths between the first and second metal reflective layers 127 and 128. Accordingly, the first to fourth cavities 121 to 124 may have a same thickness. For example, the first to fourth cavities 121 to 124 may have a thickness of from about 50 nm to about 400 nm. However, the embodiment is not limited thereto.

A lower dielectric layer 130 is provided between the resonance layer 120 and the pixel array 4100. The lower dielectric layer 130 may be provided to enhance transmittance indexes of the first to fourth unit filters 111 to 114. The lower dielectric layer 130 may include a plurality of lower pattern films (e.g., a first lower pattern film 131, a second lower pattern film 132, a third lower pattern film 133, and a fourth lower pattern film 134) provided to correspond to different center wavelengths.

The lower dielectric layer 130 may include the first lower pattern film 131, the second lower pattern film 132, the third lower pattern film 133, and the fourth lower pattern film 134. The first lower pattern film 131, the second lower pattern film 132, the third lower pattern film 133, and the fourth lower pattern film 134 may be provided under the first cavity 121, the second cavity 122, the third cavity, and the fourth cavity 124, respectively. The first to fourth lower pattern films 131 to 134 may be provided to correspond to different center wavelengths by adjusting effective refractive indexes.

Similar to the first to fourth cavities 121 to 124 described above, the first to fourth lower pattern films 131 to 134 may respectively include different second patterns respectively corresponding to the different center wavelengths. For example, the first lower pattern film 131 may have a second pattern corresponding to the first center wavelength, and the second lower pattern film 132 may have a second pattern corresponding to the second center wavelength. The third lower pattern film 133 may have a second pattern corresponding to the third center wavelength, and the fourth lower pattern film 134 may have a second pattern corresponding to the fourth center wavelength.

The second pattern of each of the first to fourth lower pattern films 131 to 134 may have a shape similar to that of the first pattern of each of the first to fourth cavities 121 to 124 described above. Each of the first to fourth lower pattern films 131 to 134 may include a third dielectric material 135a, and fourth dielectric materials 135b arranged at intervals in the third dielectric 135a to form the second pattern. Here, the fourth dielectric materials 135b may have a refractive index different from that of the third dielectric material 135a. The third and fourth dielectric materials 135a and 135b may each include, for example, titanium oxide, silicon nitride, hafnium oxide, silicon oxide, a high index polymer, or the like, but the embodiment is not limited thereto.

The second patterns may be differently formed by changing a size and/or shape of the fourth dielectric materials 136b arranged at intervals in the third dielectric material 135a, and accordingly, the lower pattern films 131 to 134 respectively corresponding to the different center wavelengths may be formed by changing an effective refractive index.

An etch stop layer 139 may be further provided on or below the third and fourth dielectric materials 135a and 135b. The etch stop layer 139 is to further facilitate a patterning process for forming the first to fourth lower pattern films 131 to 134. The etch stop layer 139 may include, for example, silicon oxide, titanium oxide, hafnium oxide, or the like, but is not limited thereto.

As described above, the first to fourth lower pattern films 131 to 134 may have different second patterns to correspond to the center wavelengths. Accordingly, like the first to fourth cavities 121 to 124 described above, the first to fourth lower pattern films 131 to 134 may be formed in a same thickness. For example, the first to fourth lower pattern films 131 to 134 may have a thickness of from about 100 nm to about 1,000 nm. However, the embodiment is not limited thereto.

An upper dielectric layer 140 is provided on the resonance layer 120. The upper dielectric layer 140 may be provided to improve transmittance indexes of the unit filters. The upper dielectric layer 140 may include a plurality of upper films (e.g., a first upper film 141, a second upper film 142, a third upper film 143, and a fourth upper film 144) provided to respectively correspond to the different center wavelengths.

The upper dielectric layer 140 may include the first upper film 141, the second upper film 142, the third upper film 143, and the fourth upper film 144. The first upper film 141, the second upper film 142, the third upper film 143, and the fourth upper film 144 may be provided above the first cavity 121, the second cavity 122, the third cavity 123, and the fourth cavity 124, respectively.

The first to fourth upper films 141 to 144 may respectively correspond to different center wavelengths. To this end, the first to fourth upper films 141 to 144 may be formed in different thicknesses to correspond to the center wavelengths. Each of the first through fourth upper films 141 through 144 may have a thickness of, for example, from about 10 nm to about 20,000 nm, but the embodiment is not limited thereto. The first to fourth upper films 141 to 144 may each include, for example, titanium oxide, silicon nitride, hafnium oxide, silicon oxide, a high index polymer, or the like, but this is merely an example. In addition, the first to fourth upper films 141 to 144 may include a compound layer including a combination of the above-stated materials. For example, the first to fourth upper films 141 to 144 may include a compound layer including titanium oxide and silicon oxide.

In the embodiment, the first to fourth cavities 121 to 124 and the first to fourth lower pattern films 131 to 134 may be manufactured in a same thickness by forming the first to fourth cavities 121 to 124 and the first to fourth lower pattern films 131 to 134 into periodical patterns by using dielectric materials having different refractive indexes. Accordingly, a manufacturing process of the spectral filter 1100 may be simplified. In addition, the manufacturing process may be further simplified by forming the first and second metal reflective layers 127 and 128 from one metal material.

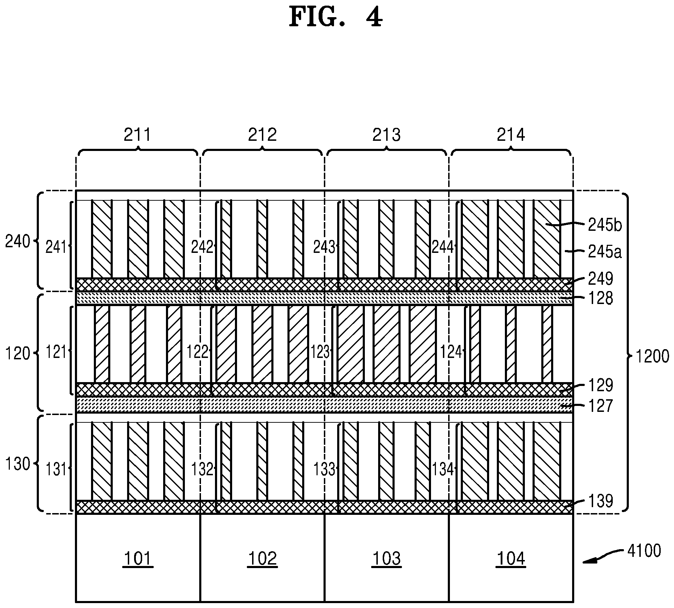

FIG. 4 is a spectral filter 1200 according to another example embodiment. Except for an upper dielectric layer 240, the spectral filter 1200 shown in FIG. 4 includes the same constituents as in the spectral filter 1100 shown in FIG. 2.

Referring to FIG. 4, the spectral filter 1200 may include a plurality of unit filters 211, 212, 213, and 214. The spectral filter 1200 includes the resonance layer 120, the lower dielectric layer 130 provided on or below the resonance layer 120, and an upper dielectric layer 240 provided on the resonance layer 120. The upper dielectric layer 240 may include a plurality of upper pattern films (e.g., a first upper pattern film 241, a second upper pattern film 242, a third upper pattern film 243, and a fourth upper pattern film 244) provided to correspond to the different center wavelengths.

The upper dielectric layer 240 may include the first upper pattern film 241, the second upper pattern film 242, the third upper pattern film 243, and the fourth upper pattern film 244. The first upper pattern film 241, the second upper pattern film 242, the third upper pattern film 243, and the fourth upper pattern film 244 may be provided above the first cavity 121, the second cavity 122, the third cavity 123, and the fourth cavity 124, respectively.

The first to fourth upper pattern films 241 to 244 may be provided to correspond to different center wavelengths by adjusting effective refractive indexes. The first to fourth upper pattern films 241 to 244 may include different third patterns respectively corresponding to the center wavelengths. For example, the first upper pattern film 241 may have a third pattern corresponding to the first center wavelength, and the second upper pattern film 242 may have a third pattern corresponding to the second center wavelength. The third upper pattern film 243 may have a third pattern corresponding to the third center wavelength, and the fourth upper pattern film 244 may have a third pattern corresponding to the fourth wavelength pattern.

The first pattern of each of the first to fourth upper pattern films 241 to 244 may have a shape similar to that of the second pattern of each of the first to fourth lower pattern films 131 to 134. Each of the first to fourth upper pattern films 241 to 244 may include a fifth dielectric material 245a, and sixth dielectric materials 245b arranged at intervals in the fifth dielectric material 245a to form the third pattern. Here, the sixth dielectric material 245b may have a refractive index different from that of the first dielectric material 245a. The fifth and sixth dielectric materials 245a and 245b may each include, for example, titanium oxide, silicon nitride, hafnium oxide, silicon oxide, a high index polymer, or the like, but the embodiment is not limited thereto.

The second patterns may be differently formed by changing a size and/or shape of the sixth dielectric materials 245b arranged at intervals in the fifth dielectric material 245a, and accordingly, the first to fourth upper pattern films 241 to 244 may be formed by changing an effective refractive index.

An etch stop layer 249 may be further provided on or below the fifth and sixth dielectric materials 245a and 245b. The etch stop layer 249 may include, for example, silicon oxide, titanium oxide, hafnium oxide, or the like, but is not limited thereto.

As described above, the first to fourth upper pattern films 241 to 244 may have different third patterns to correspond to the center wavelengths. Accordingly, like the first to fourth cavities 121 to 124 and the first to fourth lower pattern films 131 to 134, the first to fourth upper pattern films 241 to 244 may be formed in a same thickness. For example, the first to fourth upper pattern films 241 to 244 may have a thickness of from about 100 nm to about 1,000. However, the embodiment is not limited thereto.

According to the embodiment, the first to fourth upper pattern films 241 to 244, as well as the first to fourth cavities 121 to 124 and the first to fourth lower pattern films 131 to 134, may also form a periodical pattern by dielectric materials having different refractive indexes to result in further simplifying of a manufacturing process.

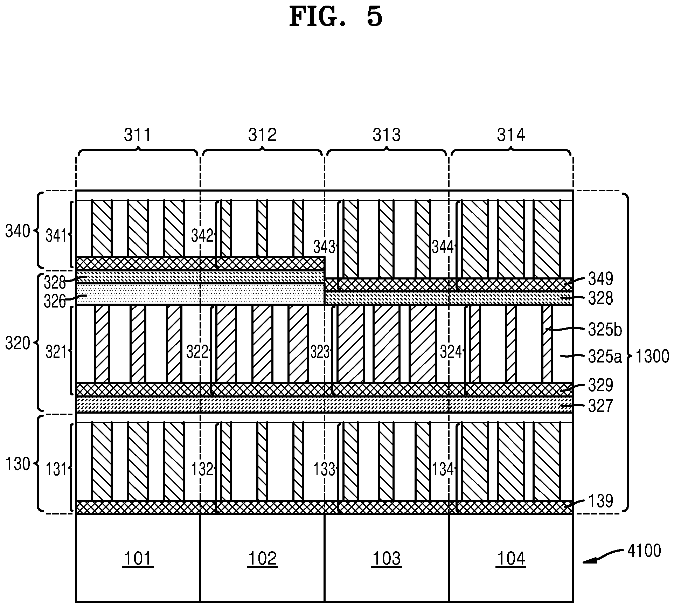

FIG. 5 shows a spectral filter 1300 according to another embodiment. Hereinafter, differences from the above-described embodiments will be mainly described.

Referring to FIG. 5, the spectral filter 1300 may include a plurality of unit filters (e.g., a first unit filter 311, a second unit filter 312, a third unit filter 313, and a fourth unit filter 314). The spectral filter 1300 includes a resonance layer 320, the lower dielectric layer 130 provided on or below the resonance layer 320, and an upper dielectric layer 340 provided on the resonance layer 320. The resonance layer 320 includes first to fourth resonators. The first, second, third, and fourth resonators may respectively include first, second, third, and fourth center wavelengths.

The resonance layer 320 includes a first metal reflective layer 327 and a second metal reflective layer 328, which are provided separate from each other, and first through fourth cavities 321, 322, 323, and 324 provided between the first metal reflective layer 327 and the second metal reflective layer 328. The first to fourth cavities 321 to 324 may have different center wavelengths by adjusting effective refractive indexes. To this end, the first to fourth cavities 321 to 324 may include different first patterns respectively corresponding to the center wavelengths.

Each of the first to fourth cavities 321 to 324 may include a first dielectric material 325a, and second dielectric materials 325b arranged at intervals in the first dielectric material 325a to form the first pattern. An etch stop layer 329 may be provided on or below the first and second dielectric materials 325a and 325b. The first to fourth cavities 321 to 324 may have, for example, a thickness of from about 50 nm to about 400 nm, but the embodiment is not limited thereto.

Each of the first to fourth cavities 321 to 324 may have a multi-mode structure having a plurality of center wavelengths. A spacer 326, which includes a certain dielectric material, may be provided in some of the first to fourth cavities 321 to 324. Due to the spacer 326, a center wavelength in a secondary mode output from a multi-mode structure of the first and second cavities 321 and 322 may be used as a center wavelength of a resonator. The spacer 326 may include, for example, silicon oxide, titanium oxide, silicon nitride, and the like, but this is merely an example. The spacer 326 may have a thickness of from about 20 nm to about 300 nm, but the embodiment is not limited thereto.

FIG. 5 shows an example of a case in which the spacer 326 is provided between the first and second cavities 321 and 322 and the second metal reflective layer 328. Due to the spacer 326 provided between the first cavity 321 and the second metal reflective layer 328, a center wavelength in a secondary mode output from the multi-mode structure of the first cavity 321 may be used as a first center wavelength of the first cavity 321. Due to the spacer 326 provided between the second cavity 322 and the second metal reflective layer 328, a center wavelength in a secondary mode in a multi-mode structure of the second cavity 322 may be used as a second center wavelength of a second resonator.

A resonator without the spacer 326 may use a center wavelength in a primary mode output from the multi-mode structure of the third and fourth cavities 323 and 324 as a center wavelength. In detail, a center wavelength in a primary mode output from the multi-mode structure of the third cavity 323 may be used as a third center wavelength of a third resonator. A center wavelength in a primary mode output from the multi-mode structure of the fourth cavity 324 may be used as a fourth center wavelength of a fourth resonator.

The lower dielectric layer 130 is provided between the resonance layer 320 and the pixel array 4100. The lower electric layer 130 may include a plurality of pattern films 131, 132, 133, and 134 (e.g. the first to fourth lower pattern films 131 to 134) provided to correspond to different center wavelengths. The first to fourth lower pattern films 131 to 134 may include different second patterns respectively corresponding to the center wavelengths.

Each of the first to fourth lower pattern films 131 to 134 may include a third dielectric material, and fourth dielectric materials arranged at intervals in the third dielectric material to form the second pattern. The etch stop layer 139 may be further provided at a lower portion of the first to fourth lower pattern films 131 to 134. The first to fourth lower pattern films 131 to 134 may have a thickness of, for example, from about 100 nm to about 1000 nm.

The upper dielectric layer 340 is provided on the resonance layer 320. The upper dielectric layer 340 may include a first upper pattern film 341, a second upper pattern film 342, a third upper pattern film 343, and a fourth upper pattern film 344 provided to correspond to different center wavelengths.

The first to fourth upper pattern films 341 to 344 may include different third patterns respectively corresponding to the center wavelengths. Each of the first to fourth upper pattern films 341 to 344 may include a fifth dielectric material, and sixth dielectric materials arranged at intervals in the fifth dielectric to form the third pattern. An etch stop layer 349 may be further provided at a lower portion of the first to fourth upper pattern films 341 to 344. The first to fourth upper pattern films 341 to 344 may have a thickness of, for example, from about 100 nm to about 1,000 nm.

An example case where the plurality of upper pattern films 341 to 344 (e.g., the first to fourth pattern films 341 to 344) are provided on the resonance layer 320 has been described above. However, a plurality of upper films (not shown) having different thicknesses, to correspond to the center wavelength, may be provided on the resonance layer 320.

In the present embodiment, by applying the spacer 326 to the first and second unit filters 311 and 312 from among the first to fourth unit filters 311 to 314, the first and second unit filters 311 and 312 may use center wavelengths in the secondary mode, which are output from the multi-mode structures of the first and second cavities 321 and 322, as the first and second center wavelengths. The third and fourth unit filters 313 and 314 may use center wavelengths in the primary mode, which are output from the multi-mode structures of the third and fourth cavities 323 and 324, as the third and fourth center wavelengths. By doing so, the spectral filter 1300 may effectively implement center wavelengths in a wide range without an additional filter such as a color filter.

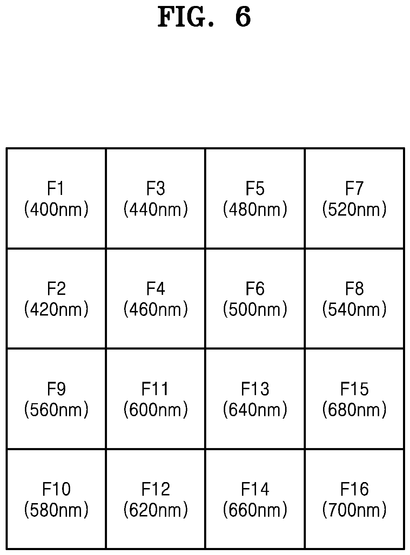

FIG. 6 shows an example of sixteen unit filters F1 to F16 arranged in a 4×4 array applied to the spectral filter 1300 of FIG. 5.

In the spectral filter shown in FIG. 6, the spacer 326 described above is applied to first to eighth unit filters F1, F2, F3, F4, F5, F6, F7, and F8, and the spacer 326 is not applied to ninth to sixteenth unit filters F9, F10, F11, F12, F13, F14, F15, and F16. Accordingly, a center wavelength in the secondary mode output from the multi-mode structure of the cavity is used as a center wavelength of the resonator in the first to eighth unit filters F1 to F8, and a center wavelength in the primary mode output from the multi-mode structure of the cavity is used as a center wavelength of the resonator in ninth to sixteenth unit filters F9 to F16.

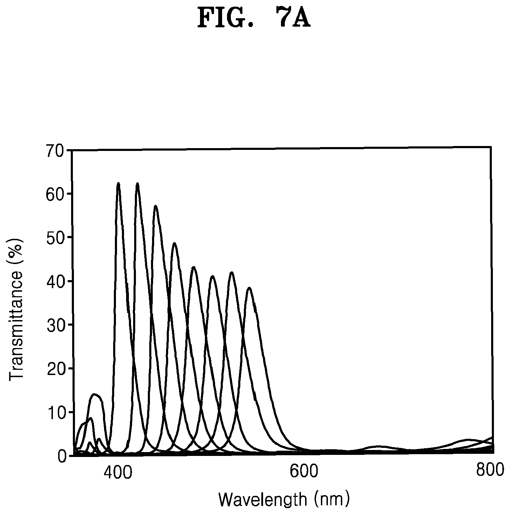

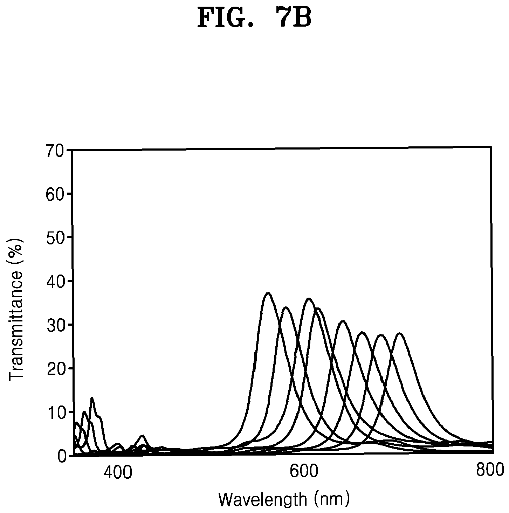

FIG. 7A illustrates transmittance spectrums of the first to eighth unit filters F1 to F8 to which the spacer 326 is applied. Referring to FIG. 7A, it is found that the first through eighth filters F1 to F8 have center wavelengths of from about 400 nm to about 540 nm. FIG. 7B shows an example of transmittance spectrums of the ninth to sixteenth unit filters F9 to F16 to which the spacer 326 is not applied. Referring to FIG. 7B, it is found that the ninth to sixteenth unit filters F9 to F16 have center wavelengths of from about 560 nm to about 700 nm.

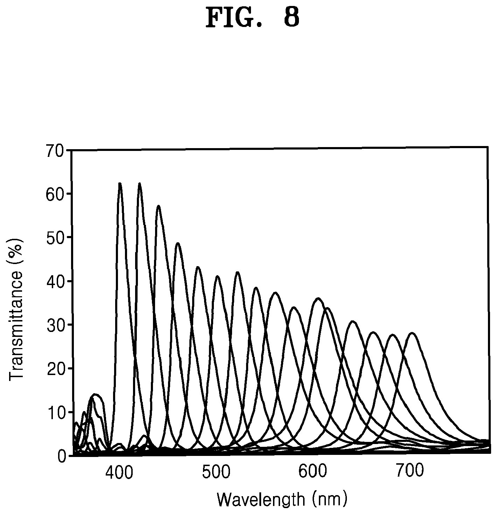

FIG. 8 shows transmittance spectrums of the first to sixteenth unit filters F1 to F16. The transmittance spectrums shown in FIG. 8 are a combination of transmittance spectrums in FIG. 7A and transmittance spectrums in FIG. 7B. Referring to FIG. 8, it is found that the first to sixteenth unit filters F1 to F16 may effectively implement the center wavelengths in a range from about 400 nm to about 700 nm.

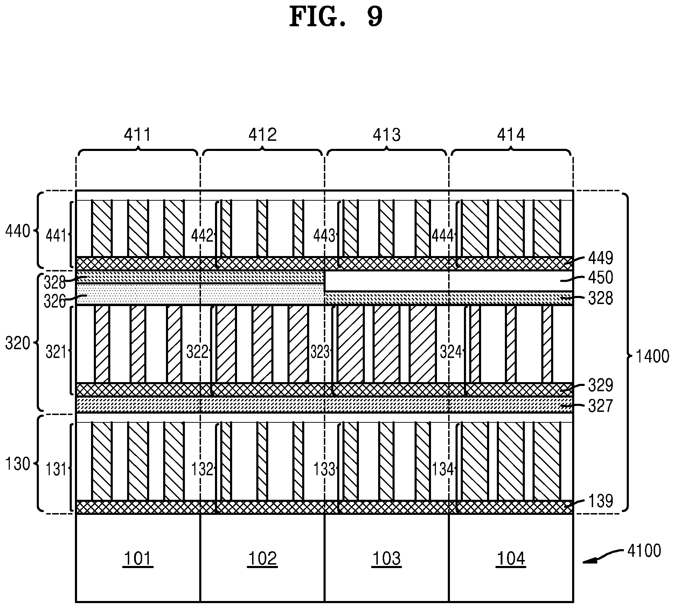

FIG. 9 shows a spectral filter 1400 according to another example embodiment. Except a planarization layer 450 provided under third and fourth unit filters 413 and 414, the spectral filter 1400 shown in FIG. 9 is identical to the spectral filter 1300 shown in FIG. 5.

Referring to FIG. 9, the spectral filter 1400 may include a plurality of unit filters (e.g., a first unit filter 411, a second unit filter 412, a third unit filter 413, and a fourth unit filter 414). The spectral filter 1400 includes the resonance layer 320, the lower dielectric layer 130 provided under the resonance layer 320, and an upper dielectric layer 440 provided on the resonance layer 320.

As described above, the spacer 326 is provided between the first and second cavities 321 and 322 and the second metal reflective layer 328, and the spacer 326 is not provided between the third and fourth cavities 323 and 324 and the second metal reflective layer 328. Accordingly, there may be a height difference corresponding to the thickness of the spacer 326 between the second metal reflective layer 328 provided with the spacer 326 and the second metal reflective layer 328 not provided with the spacer 326. Due to the height difference, a layer provided thereon may be unevenly formed.

In the embodiment, the planarization layer 450 is provided on the second metal reflective layer 328, on which the spacer 326 is not provided. Here, the planarization layer 450 may be provided to have a thickness corresponding to the height difference between the second metal reflective layer 328 provided with the spacer 326 and the second metal reflective layer 328 not provided with the spacer 326. Accordingly, a top surface of the second metal reflective layer 328 provided with the spacer 326 and a top surface of the planarization layer 450 may form a same plane, and an upper dielectric layer 440 having a certain thickness may be formed on the same plane.

The upper dielectric layer 440 may include first, second, third, and fourth upper pattern films 441, 442, 443, and 444 provided to correspond to different center wavelengths. The first to fourth upper pattern films 441 to 444 may include different third patterns corresponding to the center wavelengths. An etch stop layer 449 may be further provided at a lower portion of the first to fourth upper pattern films 441 to 444. The first to fourth upper pattern films 441 to 444 may have a thickness of, for example, from about 100 nm to about 1,000 nm.

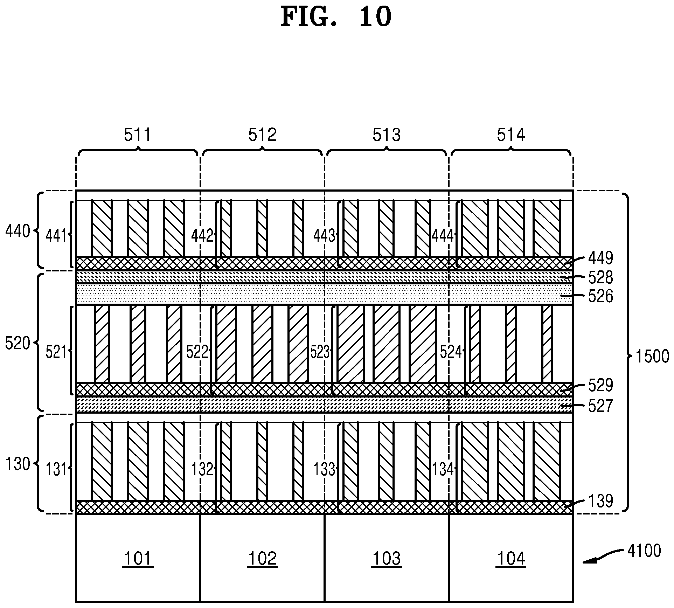

FIG. 10 shows a spectral filter 1500 according to another example embodiment.

Referring to FIG. 10, the spectral filter 1500 may include a plurality of unit filters 511, 512, 513, and 514. The spectral filter 1500 includes a resonance layer 520, the lower dielectric layer 130 provided below the resonance layer 520, and the upper dielectric layer 440 provided on the resonance layer 520.

The resonance layer 520 includes a first metal reflective layer 527 and a second metal reflective layer 528, which are provided separate from each other, and first through fourth cavities 521, 522, 523, and 524 provided between the first metal reflective layer 527 and the second metal reflective layer 528. The first through fourth cavities 521 to 524 may include different first patterns corresponding to the center wavelengths. An etch stop layer 529 may be further provided at a lower portion of below the first to fourth cavities 521 to 524. The first to fourth cavities 521 to 524 may have a thickness of, for example, from about 50 nm to about 400 nm, but the embodiment is not limited thereto.

Each of the first to fourth cavities 521 to 524 may have a multi-mode structure having a plurality of center wavelengths. A spacer 526 is provided between the first to fourth cavities 521 to 524 and the second metal reflective layer 528. As described above, due to the spacer 526, a center wavelength in a secondary mode output from the multi-mode structure from each of the first to fourth cavities 521 to 524 may be used as a center wavelength of each resonator. The spacer 526 may include, for example, silicon oxide, titanium oxide, silicon nitride, and the like, but this is merely an example. The spacer 526 may have a thickness of from about 20 nm to about 300 nm, but is not limited thereto.

The lower electric layer 130 may include a plurality of pattern films (e.g., the first to fourth lower pattern films 131 to 134) provided to correspond to different center wavelengths. The first lower pattern film 131, the second lower pattern film 132, the third lower pattern film 133, and the fourth lower pattern film 134 may include different second patterns corresponding to center wavelengths. The etch stop layer 139 may be further provided at a lower portion of the first to fourth lower pattern films 131 to 134. The first to fourth lower pattern films 131 to 134 may have a thickness of, for example, from about 100 nm to about 1,000 nm.

The upper dielectric layer 440 is provided on the resonance layer 520. The upper dielectric layer 440 may include first, second, third, and fourth upper pattern films 441, 442, 443, and 444 provided to correspond to different center wavelengths. The first to fourth upper pattern films 441 to 444 may include different third patterns corresponding to the center wavelengths. An etch stop layer 449 may be further provided below at a lower portion of the first to fourth upper pattern films 441 to 444. The first to fourth upper pattern films 441 to 444 may have a thickness of, for example, from about 100 nm to about 1,000 nm.

An example case where the plurality of upper pattern films (e.g., the first to fourth upper pattern films 441 to 444) are provided on the resonance layer 520 has been described above. However, a plurality of upper films (not shown) having different thicknesses, to correspond to the center wavelengths, may be provided on the resonance layer 520.

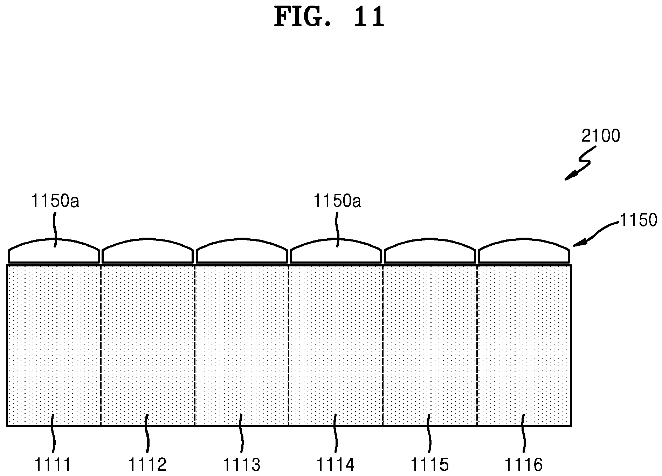

FIG. 11 shows a spectral filter 2100 according to another example embodiment.

Referring to FIG. 11, the spectral filter 2100 includes a plurality of unit filters (e.g., a first unit filter 1111, a second unit filter 1112, a third unit filter 1113, a fourth unit filter 1114, a fifth unit filter 1115, and a sixth unit filter 1116), and a microlens array 1150 provided in the plurality of unit filters 1111 to 1116. Here, the plurality of unit filters (e.g., the first to sixth unit filters 1111 to 1116) may include the unit filters described in the embodiments.

The microlens array 1150 having a plurality of microlenses 1150a may be provided on or above the plurality of unit filters 1111 to 1116. Each of the microlenses 1150a may focus external light to be incident on corresponding unit filters 1111 to 1116.

FIG. 11 illustrates a case in which the microlenses 1150a are provided to have a one-to-one correspondence to the unit filters 1111 to 1116. However, this is merely an example, and at least two of the unit filters 1111 to 1116 may be provided corresponding to one microlens 1150a.

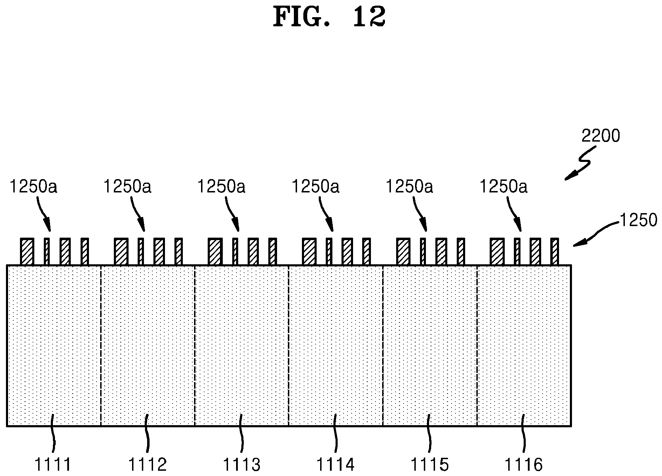

FIG. 12 shows a spectral filter 2200 according to another example embodiment.

Referring to FIG. 12, a nanopattern array 1250 including a plurality of nanopatterns 1250a may be provided on the plurality of unit filters 1111 to 1116. Each of the nanopatterns 1250a may focus external light to be incident on corresponding unit filters 1111 to 1116. Although FIG. 12 illustrates a case in which the nanopatterns 1250a are provided to have a one-to-one correspondence to the unit filters 1111 to 1116, at least two of the unit filters 1111 to 1116 may be provided corresponding to one nanopattern 1250a.

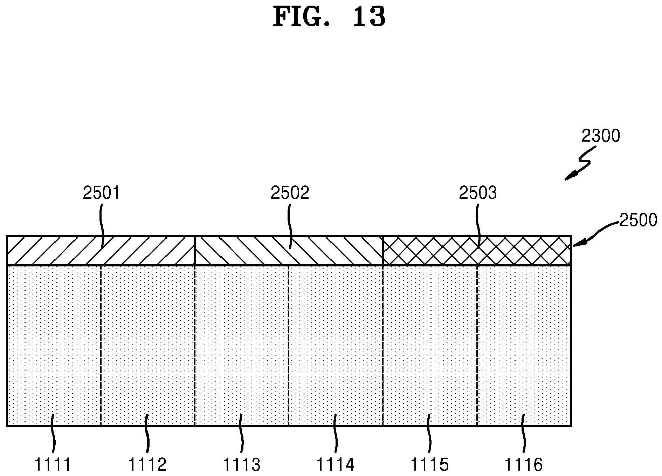

FIG. 13 shows a spectral filter 2300 according to another example embodiment.

Referring to FIG. 13, an additional filter array 2500 is provided on the plurality of unit filters 1111 to 1116. The additional filter array 2500 may include a plurality of additional filters (e.g., a first additional filter 2501, a second additional filter 2502, and a third additional filter 2503). FIG. 13 illustrates a case in which the first additional filter 2501 is provided to correspond to the first unit filter 1111 and the second unit filter 1112, the second additional filter 2502 is provided to correspond to the third unit filter 1113 and the fourth unit filter 1114, and the third additional filter 2503 is provided to correspond to the fifth unit filter 1115 and the sixth unit filter 1116. However, this is merely an example, and each of the first, second, and third unit filters 2501, 2502, and 2503 may be provided to correspond to one of the unit filters 1111 to 1116, or may be provided to correspond to at least three of the unit filters 1111 to 1116.

Each of the first, second, and third additional filters 2501, 2502, and 2503 may block light in a wavelength band that the corresponding unit filters 1111 to 1116 do not desire. For example, when the first and second unit filters 1111 and 1112 have center wavelengths in a wavelength band of from about 400 nm to about 500 nm, the first additional filter 2501 may include a blue filter that transmits blue light. Furthermore, when the third and fourth unit filters 1113 and 1114 have center wavelengths in a wavelength band of about 500 nm to about 600 nm, the second additional filter 2502 may include a green filter that transmits green light. When the fifth and sixth unit filters 1115 and 1116 have center wavelengths in a wavelength band of about 600 nm to about 700 nm, the third additional filter 2503 may include a red filter that transmits red light.

The additional filter array 2500 may include a color filter array. In this case, the first, second, and third additional filters 2501, 2502, and 2503 may respectively include blue, green, and red color filters. For example, typical color filters applied to color display apparatuses such as liquid crystal display apparatus, organic light-emitting display apparatuses, and the like may be used as the blue, green, and red color filters.

The additional filter array 2500 may include a broadband filter array. In this case, the first, second, and third additional filters 2501, 2502, and 2503 may respectively include first, second, and third broadband filters. Each of the first, second, and third broadband filters may have, for example, a multi-cavity structure or a metal mirror structure.

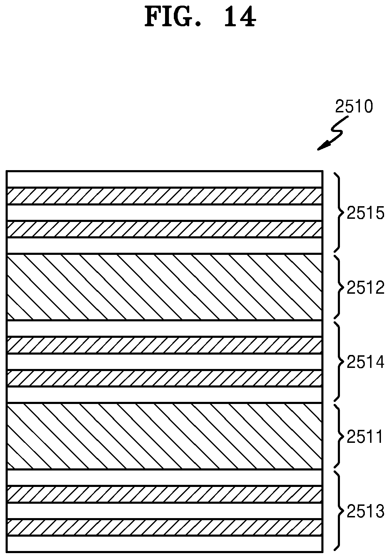

FIG. 14 is a schematic cross-sectional view of a broadband filter 2510 that is usable as the additional filters 2501, 2502, and 2503 of FIG. 13.

Referring to FIG. 14, the broadband filter 2510 may include a plurality of reflective layers 2513, 2514, and 2515 and a plurality of cavities 2511 and 2512 provided between the reflective layers 2513, 2514, and 2515. Although FIG. 14 illustrates an example of the three reflective layers 2513, 2514, and 2515 and the two cavities 2511 and 2512, the numbers of reflective layers 2513, 2514, and 2515 and cavities 2511 and 2512 may be variously changed.

Each of the reflective layers 2513, 2514, and 2515 may include a distributed Bragg reflector (DBR). Each of the reflective layers 2513, 2514, and 2515 may have a structure in which a plurality of material layers having different refractive indexes are alternately stacked. Each of the cavities 2511 and 2512 may include a material having a certain refractive index or two or more materials having different refractive indexes.

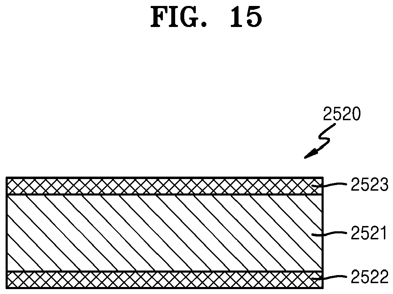

FIG. 15 is a schematic cross-sectional view of a broadband filter 2520 that is usable as the additional filters 2501, 2502, and 2503 of FIG. 13, according to another embodiment. Referring to FIG. 15, the broadband filter 2520 may include two metal mirror layers 2522 and 2523, which are arranged spaced apart from each other, and a cavity 2521 provided between the metal mirror layers 2522 and 2523.

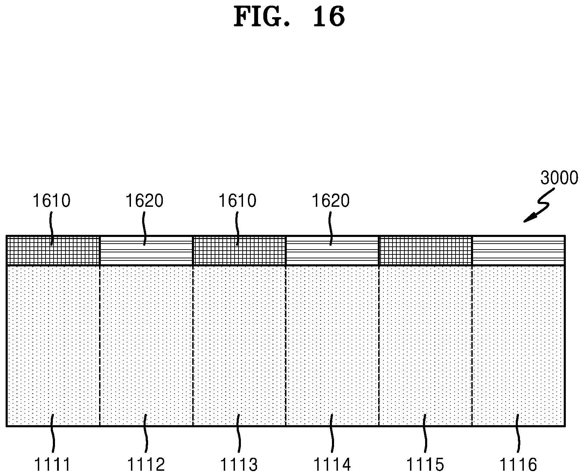

FIG. 16 is a schematic cross-sectional view of a spectral filter 3000 according to another embodiment.

Referring to FIG. 16, at least one short wavelength absorption filter 1610 and at least long wavelength cut-off filter 1620 are provided in the plurality of unit filters 1111 to 1116. The short wavelength absorption filter 1610 may be provided in some unit filters 1111, 1113, and 1115 from among the unit filters 1111 through 1116, and the long wavelength cut-off filter 1620 may be provided in the other unit filters 1112, 1114, and 1116 from among the unit filters 1111 through 1116. Although FIG. 16 illustrates a case in which each of the short wavelength absorption filter 1610 and the long wavelength cut-off filter 1620 is provided to correspond to one of the unit filters 1111 to 1116, the disclosure is not limited thereto, and each of the short wavelength absorption filter 1610 and the long wavelength cut-off filter 1620 may be provided to correspond to two or more of the unit filters 1111 to 1116.

The short wavelength absorption filter 1610 may cut off, for example, light of a short wavelength such as visible light. The short wavelength absorption filter 1610 may be manufactured by depositing, for example, silicon that is a material for absorbing visible light, on some unit filters 1111, 1113, and 1115 from among the unit filters 1111 to 1116. The unit filters 1111, 1113, and 1115, where the short wavelength absorption filter 1610 is provided, may transmit near infrared (NIR) light having a wavelength longer than that of visible light.

The long wavelength cut-off filter 1620 may cut off, for example, light having a long wavelength such as NIR light. The long wavelength cut-off filter 1620 may include a NIR light cut-off filter. The unit filters 1112, 1114, and 1116 in which the long wavelength cut-off filter 1620 is provided may transmit visible light having a wavelength shorter than that of NIR light.

According to an embodiment, as the short wavelength absorption filter 1610 and the long wavelength cut-off filter 1620 are provided in the plurality of unit filters 1111 to 1116, the spectral filter 3000 having the broadband characteristics capable of implementing from a visible light band to an NIR band may be manufactured.

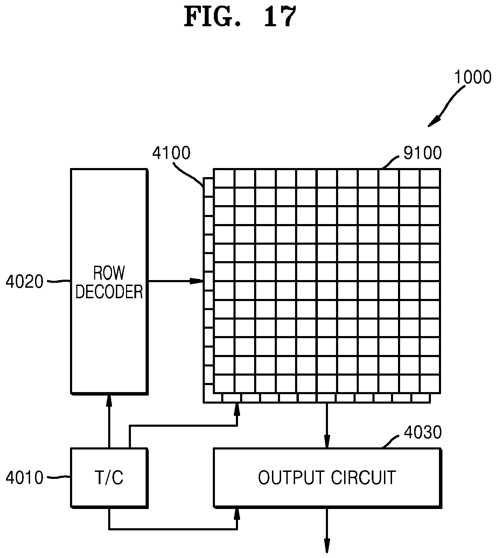

FIG. 17 is a schematic block diagram of an image sensor according to an example embodiment.

Referring to FIG. 17, an image sensor 1000 may include a spectral filter 9100, the pixel array 4100, a timing controller 4010, a row decoder 4020, and an output circuit 4030. The image sensor may include a CCD image sensor or a CMOS image sensor, but is not limited thereto.

The spectral filter 9100 includes a plurality of unit filters respectively transmitting light of different wavelength ranges and being arranged in two dimensions. The pixel array 4100 includes a plurality of pixels configured to sense light of different wavelength ranges that is transmitted through the plurality of unit filters. In detail, the pixel array 4100 includes pixels arranged in two dimensions in rows and columns. The row decoder 4020 selects one of the rows of the pixel array 4100, in response to a row address signal output from the timing controller 4010. The output circuit 4030 outputs light sensing signals in column units from the pixels arranged in the selected row. To this end, the output circuit 4030 may include a column decoder and an analog-to-digital converter (ADC). For example, the output circuit 4030 may include a plurality of ADCs arranged according to columns between the column decoder and the pixel array 4100, or an ADC arranged at an output terminal of the column decoder. The timing controller 4010, the row decoder 4020, and the output circuit 4030 may be implemented as a single chip or individual chips. A processor configured to process image signals output from the output circuit 4030 may be implemented as a single chip together with the timing controller 4010, the row decoder 4020, and the output circuit 4030. The pixel array 4100 includes a plurality of pixels sensing light of different wavelength ranges, and arrangement of the pixels may be implemented in various manners.

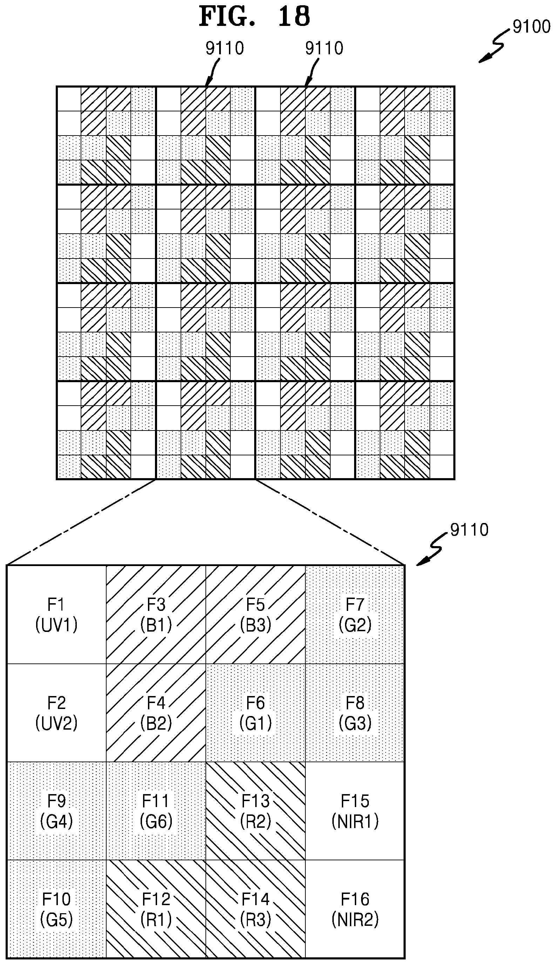

FIG. 18 is an example of a top-plan view of the spectral filter 9100 that is applicable to the image sensor 1100 of FIG. 17.

Referring to FIG. 18, the spectral filter 9100 may include a plurality of filter groups 9110 arranged in two dimensions. Each of the filter groups 9110 may include sixteen unit filters F1 to F16 arranged in a 4x4 array.

The first and second unit filters F1 and F2 may have center wavelengths UV1 and UV2 in an ultraviolet range, and the third to fifth unit filters F3 to F5 may have center wavelengths B1 to B3 in a blue light range. The sixth to eleventh unit filters F6 to F11 may have center wavelengths G1 to G6 in a green light range, and the twelfth to fourteenth unit filters F12 to F14 may have center wavelengths R1 to R3 in a red light range. The fifteenth and sixteen unit filters F15 and F16 may have center wavelengths NIR1 and NIR2 in a near infrared range.

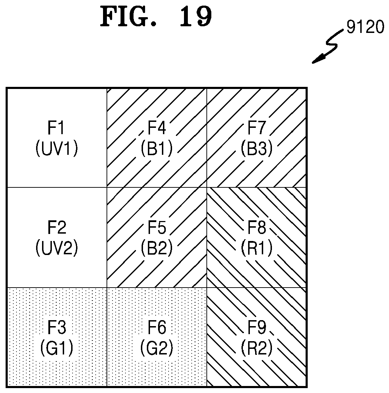

FIG. 19 is a plan view of another example of the spectral filter 9100 that is applicable to the image sensor of FIG. 17. FIG. 19 is a plan view of one filter group 9120, for convenience of explanation.

Referring to FIG. 19, each filter group 9120 may include nine unit filters F1 to F9 arranged in a 3x3 array. Here, the first and second unit filters F1 and F2 may have center wavelengths UV1 and UV2 in the ultraviolet range, and the fourth, fifth, and seventh unit filters F4, F5, and F7 may have center wavelengths B1 to B3 in the blue light range. The third and sixth unit filters F3 and F6 may have center wavelengths G1 and G2 in a green light range, and the eighth and ninth filters F8 and F9 may have center wavelengths R1 and R2 in a red light range.

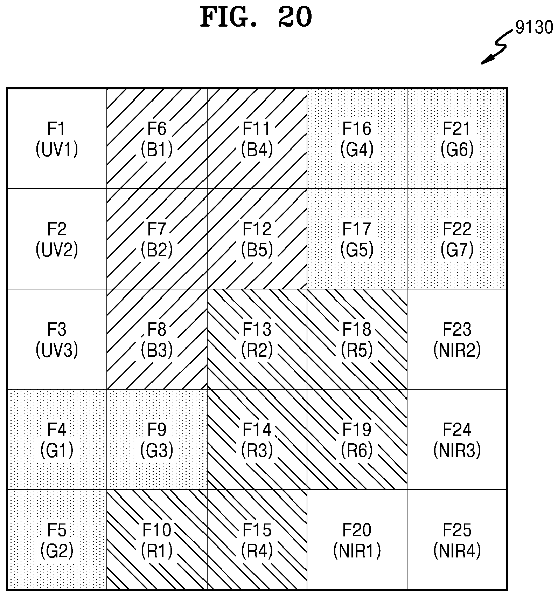

FIG. 20 is a plan view of another example of the spectral filter 9100 that is applicable to the image sensor 1000 of FIG. 17. FIG. 20 is a plan view of one filter group 9130, for convenience of explanation.

Referring to FIG. 20, each filter group 9130 may include twenty-five unit filters F1 to F25 arranged in a 5x5 array. The first to third unit filters F1 to F3 may have center wavelengths UV1 to UV3, and the sixth, seventh, eighth, eleventh, and twelfth unit filters F6, F7, F8, F11, and F12 may have center wavelengths B1 to B5 in the blue light range. The fourth, fifth, and ninth unit filters F4, F5, and F9 may have center wavelengths G1 to G3 in the green light range, and the tenth, thirteenth, fourteenth, fifteenth, eighteenth, and nineteenth unit filters F10, F13, F14, F15, F18, and F19 may have center wavelengths R1 to R6 in the red light range. The twentieth, twenty-third, twenty-fourth, and twenty-fifth unit filters F20, F23, F24, and F25 may have center wavelengths NIR1 to NIR4 in the NIR range.

The image sensor 1000 including any one or the above-described spectral filters may be employed in various high-performance optical devices or high-performance electronic devices. The electronic devices may include, for example, smartphones, mobile phones, cellular phones, personal digital assistants (PDAs), laptop computers, personal computers (PCs), various portable devices, home appliances, security cameras, medical cameras, automobiles, Internet of Things (loT) devices, and other mobile or non-mobile computing devices, but are not limited thereto.

The electronic devices may further include, in addition to the image sensor 1000, a processor configured to control an image sensor, for example, an application processor (AP), control a number of hardware or software constituent elements by driving operating systems or application programs through the processor, and perform various data processing and calculations. The processors may further include graphics processing units (GPUs) and/or image signal processors. When the processors include image signal processors, an image (or video) obtained through an image sensor may be stored and/or output using the processor.

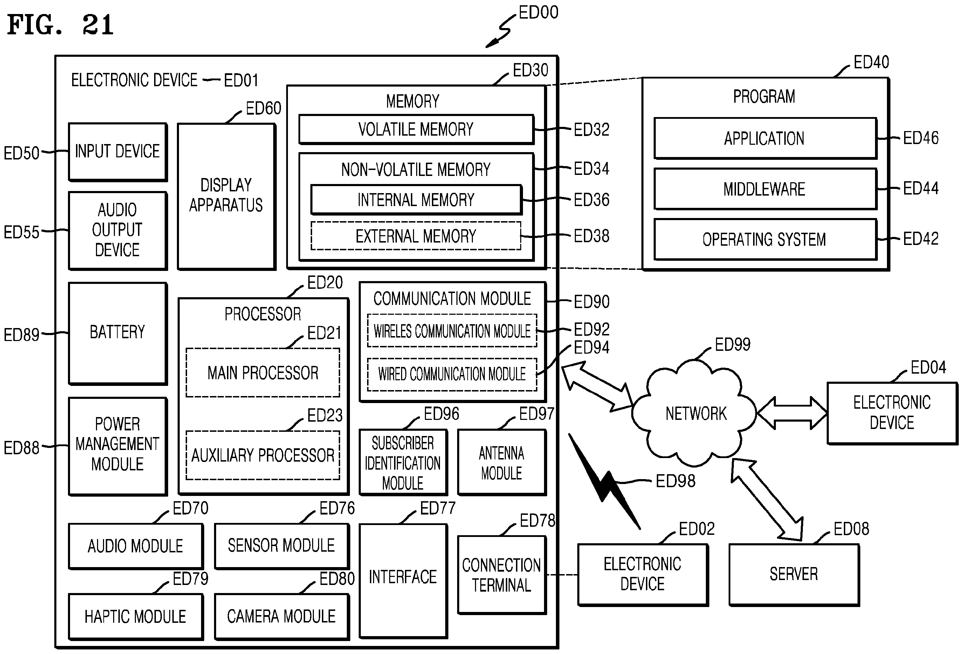

FIG. 21 is a schematic block diagram of an electronic device ED01 including the image sensor 1000, according to an embodiment. Referring to FIG. 21, in a network environment ED00, the electronic device ED01 may communicate with another electronic device ED02 through a first network ED98 (e.g., a short-range wireless communication network, and the like), or communicate with another electronic device ED04 and/or a server ED08 through a second network ED99 (e.g., a long-range wireless communication network, and the like). The electronic device ED01 may communicate with the electronic device ED04 through the server ED08. The electronic device ED01 may include a processor ED20, a memory ED30, an input device ED50, an audio output device ED55, a display device ED60, an audio module ED70, a sensor module ED70, an interface ED77, a haptic module ED79, a camera module ED80, a power management module ED88, a battery ED89, a communication module ED90, a subscriber identification module ED96, and/or an antenna module ED97. In the electronic device ED01, some (e.g., the display device ED60, and the like) of constituent elements may be omitted, or other constituent elements may be added. Some of the constituent elements may be implemented by one integrated circuit. For example, the sensor module ED76 (e.g., a fingerprint sensor, an iris sensor, an illuminance sensor, and the like) may be implemented by being embedded in the display device ED60 (e.g., a display, and the like). Furthermore, when the image sensor 1000 includes a spectral function, some functions (e.g., a color sensors and an illuminance sensor) of the sensor module may be implemented by the image sensor 1000, not by a separate sensor module.

The processor ED20 may control one or a plurality of other constituent elements (e.g., hardware and software constituent elements, and the like) of the electronic device ED01 connected to the processor ED20 by executing software (e.g., a program ED40, and the like), and perform various data processing or calculations. As part of the data processing or calculations, the processor ED20 may load, in a volatile memory ED32, commands and/or data received from other constituent elements (e.g., the sensor module ED76, the communication module ED90, and the like), process the command and/or data stored in the volatile memory ED32, and store result data in a non-volatile memory ED34. The processor ED20 may include a main processor ED21 (e.g., a central processing unit, an application processor, and the like) and an auxiliary processor ED23 (e.g., a graphics processing unit, an image signal processor, a sensor hub processor, a communication processor, and the like) that is operable independently of or together with the main processor ED21. The auxiliary processor ED23 may use less power than the main processor ED21 and may perform a specialized function.

Instead of the main processor ED21 when the main processor ED21 is in an inactive state (e.g., sleep state), or with the main processor ED21 when the main processor ED21 is in an active state (e.g., application execution state), the auxiliary processor ED23 may control functions and/or states related to some constituent elements (e.g., the display device ED60, the sensor module ED76, the communication module ED90, and the like) of the constituent elements of the electronic device ED01. The auxiliary processor ED23 (e.g., an image signal processor, a communication processor, and the like) may be implemented as a part of functionally related other constituent elements (e.g., the camera module ED80, the communication module ED90, and the like).

The memory ED30 may store various data needed by the constituent elements (e.g., the processor ED20, the sensor module ED76, and the like) of the electronic device ED01. The data may include, for example, software (e.g., the program ED40, and the like) and input data and/or output data about commands related thereto. The memory Ed30 may include the volatile memory ED32 and/or the non-volatile memory ED34. The non-volatile memory ED34 may include an internal memory ED36 fixedly installed in the electronic device ED01 and an external memory ED38 that is removable.

The program ED40 may be stored in the memory ED30 as software, and may include an operating system ED42, middleware ED44, and/or an application ED46.

The input device ED50 may receive commands and/or data to be used for constituent elements (e.g., the processor ED20, and the like) of the electronic device ED01, from the outside (e.g., a user, and the like) of the electronic device ED01. The input device ED50 may include a microphone, a mouse, a keyboard, and/or a digital pen (e.g., a stylus pen, and the like).

The audio output device ED55 may output an audio signal to the outside of the electronic device ED01. The audio output device ED44 may include a speaker and/or a receiver. The speaker may be used for general purposes such as multimedia playback or recording playback, and the receiver may be used to receive incoming calls. The receiver may be implemented by being coupled as a part of the speaker or by an independent separate device.

The display device ED60 may visually provide information to the outside of the electronic device ED01. The display device ED60 may include a display, a hologram device, or a projector, and a control circuit to control a corresponding device. The display device ED60 may include a touch circuitry set to detect a touch and/or a sensor circuit (e.g., a pressure sensor, and the like) set to measure the strength of a force generated by the touch.

The audio module ED70 may convert sound into electrical signals or reversely electrical signals into sound. The audio module ED70 may obtain sound through the input device ED50, or output sound through a speaker and/or a headphone of another electronic device (e.g., the electronic device ED02, and the like) connected to the audio output device ED55 and/or the electronic device ED01 in a wired or wireless manner.

The sensor module ED76 may detect an operation sate (e.g., power, temperature, and the like) of the electronic device ED01, or an external environment state (e.g., a user state, and the like), and generate an electrical signal and/or a data value corresponding to the detected state. The sensor module ED76 may include a gesture sensor, a gyro sensor, a barometic pressure sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor.

The interface ED77 may support one or a plurality of specified protocols used for the electronic device ED01 to be connected to another electronic device (e.g., the electronic device ED02, and the like) in a wired or wireless manner. The interface ED77 may include a high definition multimedia interface (HDMI), a universal serial bus (USB) interface, an SD card interface, and/or an audio interface.

The connection terminal ED78 may include a connector for the electronic device ED01 to be physically connected to another electronic device (e.g., the electronic device ED02, and the like). The connection terminal ED78 may include an HDMI connector, a USB connector, an SD card connector, and/or an audio connector (e.g., a headphone connector, and the like).

The haptic module ED79 may convert electrical signals into mechanical stimuli (e.g., vibrations, movements, and the like) or electrical stimuli that are perceivable by a user through tactile or motor sensations. The haptic module Ed79 may include a motor, a piezoelectric device, and/or an electrical stimulation device.

The camera module ED80 may capture a still image and a video. The camera module ED80 may include a lens assembly including one or a plurality of lenses, the image sensor 1000 of FIG. 1, image signal processors, and/or flashes. The lens assembly included in the camera module ED80 may collect light emitted from a subject for image capturing.

The power management module ED88 may manage power supplied to the electronic device ED01. The power management module ED88 may be implemented as a part of a power management integrated circuit (PMIC).

The battery ED89 may supply power to the constituent elements of the electronic device ED01. The battery ED89 may include non-rechargeable primary cells, rechargeable secondary cells, and/or fuel cells.

The communication module ED90 may establish a wired communication channel and/or a wireless communication channel between the electronic device ED01 and another electronic device (e.g., the electronic device ED02, the electronic device ED04, the server ED08, and the like), and support a communication through an established communication channel. The communication module ED90 may be operated independent of the processor ED20 (e.g., the application processor, and the like), and may include one or a plurality of communication processors supporting a wired communication and/or a wireless communication. The communication module ED90 may include a wireless communication module ED92 (e.g., a cellular communication module, a short-range wireless communication module, a global navigation satellite system (GNSS) communication module, and the like), and/or a wired communication module ED94 (e.g., a local area network (LAN) communication module, a power line communication module, and the like). Among the above communication modules, a corresponding communication module may communicate with another electronic device through the first network ED98 (e.g., a short-range communication network such as Bluetooth, WiFi Direct, or infrared data association (IrDA)) or the second network ED99 (e.g., a long-range communication network such as a cellular network, the Internet, or a computer network (e.g., LAN, WAN, and the like)). These various types of communication modules may be integrated into one constituent element (e.g., a single chip, and the like), or may be implemented as a plurality of separate constituent elements (e.g., multiple chips). The wireless communication module ED92 may verify and authenticate the electronic device ED01 in a communication network such as the first network ED09 and/or the second network ED99 by using subscriber information (e.g., an international subscriber identifier (IMSI), and the like) stored in the subscriber identification module ED96.

The antenna module ED97 may transmit signals and/or power to the outside (e.g., another electronic device, and the like) or receive signals and/or power from the outside. An antenna may include an emitter formed in a conductive pattern on a substrate (e.g., a printed circuit board (PCB), and the like). The antenna module ED97 may include one or a plurality of antennas. When the antenna module ED97 includes a plurality of antennas, the communication module ED90 may select, from among the antennas, an appropriate antenna for a communication method used in a communication network such as the first network ED98 and/or the second network ED99. Signals and/or power may be transmitted or received between the communication module ED90 and another electronic device through the selected antenna. Other parts (e.g., an RFIC, and the like) than the antenna may be included as a part of the antenna module ED97.

Some of the constituent elements may be connected to each other through a communication method between peripheral devices (e.g., a bus, general purpose input and output (GPIO), a serial peripheral interface (SPI), a mobile industry processor interface (MIPI), and the like) and may mutually exchange signals (e.g., commands, data, and the like).

The command or data may be transmitted or received between the electronic device ED01 and the external electronic device ED04 through the server ED08 connected to the second network ED99. The electronic devices ED02 and ED04 may be of a type that is the same as or different from the electronic device ED01. All or a part of operations executed in the electronic device ED01 may be executed in one or a plurality of the electronic devices (e.g., ED02, ED04, and ED08). For example, when the electronic device ED01 needs to perform a function or service, the electronic device ED01 may request one or a plurality of electronic devices to perform part of the whole of the function or service, instead of performing the function or service. The one or the plurality of electronic devices receiving the request may perform additional function or service related to the request, and transmit a result of the performance to the electronic device ED01. To this end, cloud computing, distributed computing, and/or client-server computing technology may be used.

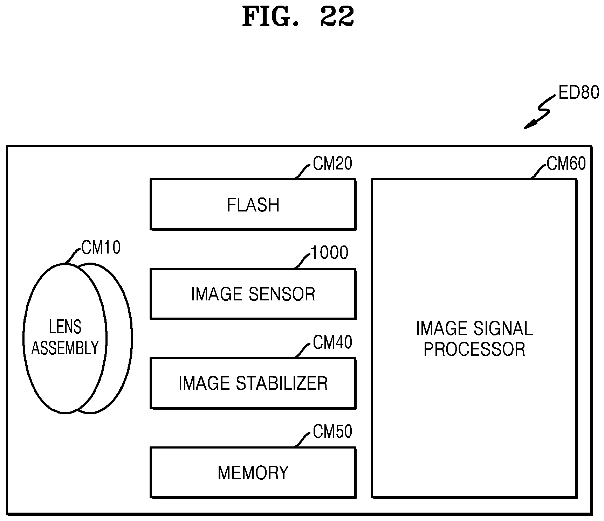

FIG. 22 is a block diagram of the camera module ED80 of FIG. 21. Referring to FIG. 22, the camera module ED80 may include a lens assembly CM10, a flash CM20, the image sensor 1000 (e.g., the image sensor 1000 of FIG. 17, and the like), an image stabilizer CM40, a memory CM50 (e.g., a buffer memory, and the like), and/or an image signal processor CM60. The lens assembly CM10 may collect light emitted from a subject for image capturing. The camera module ED80 may include a plurality of lens assemblies CM10, and in this case, the camera module ED80 may include a dual camera, a 360 degrees camera, or a spherical camera. Some of the lens assemblies CM10 may have the same lens attributes (e.g., a viewing angle, a focal length, auto focus, F number, optical zoom, and the like), or different lens attributes. The lens assembly CM10 may include a wide angle lens or a telescopic lens.

The flash CM20 may emit light used to reinforce light emitted or reflected from a subject. The flash CM20 may include one or a plurality of light-emitting diodes (e.g., a red-green-blue (RGB) LED, a white LED, an infrared LED, an ultraviolet LED, and the like), and/or a xenon lamp. The image sensor 1000 may include the image sensor of FIG. 1, and convert light emitted or reflected from the subject and transmitted through the lens assembly CM10 into electrical signals, thereby obtaining an image corresponding to the subject. The image sensor 1000 may include one or a plurality of sensors selected from among image sensors having different attributes such as an RGB sensor, a black and white (BW) sensor, an IR sensor, or a UV sensor. Each sensor included in the image sensor 1000 may be implemented by a charged coupled device (CCD) sensor and/or a complementary metal oxide semiconductor (CMOS) sensor.

The image stabilizer CM40 may move, in response to a movement of the camera module ED80 or an electronic device ED01 including the same, one or a plurality of lenses included in the lens assembly CM10 or the image sensor 1000 in a particular direction or may compensate a negative effect due to the movement by controlling (e.g., adjusting a read-out timing, and the like) the movement characteristics of the image sensor 1000. The image stabilizer CM40 may detect a movement of the camera module ED80 or the electronic device ED01 by using a gyro sensor (not shown) or an acceleration sensor (not shown) arranged inside or outside the camera module ED80. The image stabilizer CM40 may be implemented in an optical form.

The memory CM50 may store a part or the entire data of an image obtained through the image sensor 1000 for a subsequent image processing operation. For example, when a plurality of images are obtained at a high speed, only low resolution images are displayed while the obtained original data (e.g., Bayer-Patterned data, high resolution data, and the like) is stored in the memory CM50. Then, the memory CM50 may be used to transmit the original data or a selected (e.g., user selection, and the like) image to the image signal processor CM60. The memory CM50 may be incorporated into the memory ED30 of the electronic device ED01, or configured to be a separate memory that is independently operated.

The image signal processor CM60 may perform image processing on the image obtained through the image sensor 1000 or the image data stored in the memory CM50. The image processing may include depth map generation, three-dimensional modeling, panorama generation, feature point extraction, image synthesis, and/or image compensation (e.g., noise reduction, resolution adjustment, brightness adjustment, blurring, sharpening, softening, and the like). The image signal processor CM60 may perform control (e.g., exposure time control, or read-out timing control, and the like) on constituent elements (e.g., the image sensor 1000, and the like) included in the camera module ED80. The image processed by the image signal processor CM60 may be stored again in the memory CM50 for additional processing or provided to external constituent elements (e.g., the memory ED30, the display device ED60, the electronic device ED02, the electronic device ED04, the server ED08, and the like) of the camera module ED80. The image signal processor CM60 may be incorporated into the processor ED20, or configured to a separate processor that is operated independent of the processor ED20. When the image signal processor CM60 is configured by a separate processor from the processor ED20, the image processed by the image signal processor CM60 may undergo additional image processing by the processor ED20 and then displayed through the display device ED60.

The electronic device ED01 may include a plurality of camera modules ED80 having different attributes or functions. In this case, one of the camera modules ED80 may include a wide angle camera, and another may include a telescopic camera. Similarly, one of the camera modules ED80 may include a front side camera, and another may include a rear side camera.

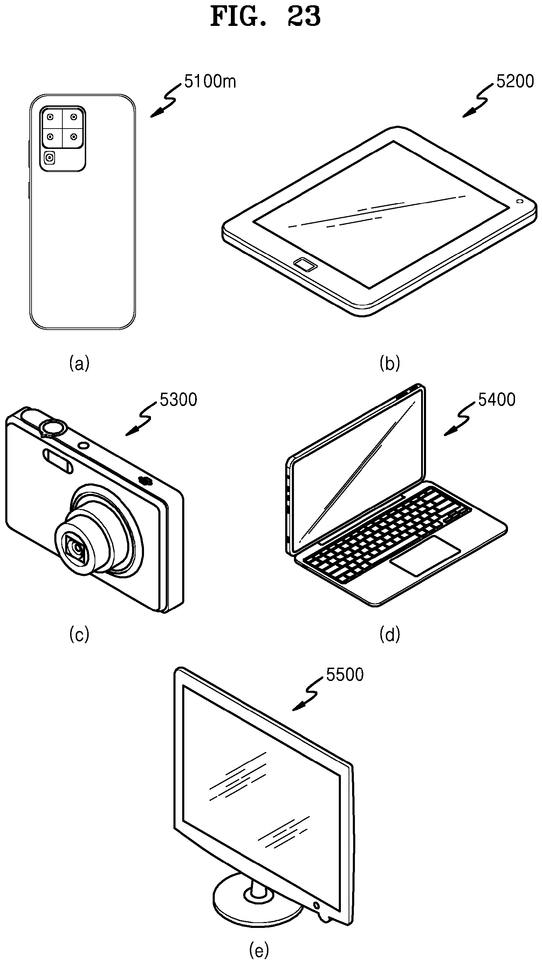

The image sensor 1000 according to embodiments may be applied to a mobile phone or smartphone 5100m illustrated in (a) of FIG. 23, a tablet or smart tablet 5200 illustrated in (b) of FIG. 23, a digital camera or camcorder 5300 illustrated in (c) of FIG. 23, a notebook computer 5400 illustrated in (d) of FIG. 23, a television or smart television 5500 illustrated in (e) of FIG. 23, or the like. For example, the smartphone 5100m or the smart tablet 5200 may include a plurality of high resolution cameras, each having a high resolution image sensor mounted thereon. Depth information of subjects in an image may be extracted by using a high resolution cameras, out focusing of the image may be adjusted, or subjects in the image may be automatically identified.

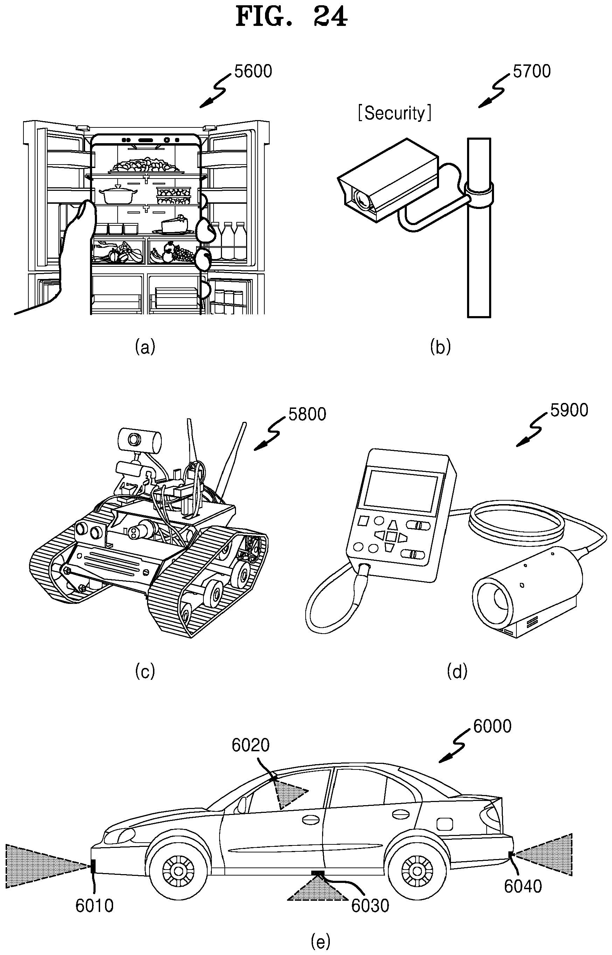

Furthermore, the image sensor 1000 may be applied to a smart refrigerator 5600 illustrated in (a) of FIG. 24, a security camera illustrated in (b) of FIG. 24, a robot 5800 illustrated in (c) of FIG. 24, a medical camera 5900 illustrated in (d) of FIG. 24, and the like. For example, the smart refrigerator 5600 may automatically recognize food in a refrigerator, by using an image sensor, and notify a user of the presence of a particular food, the type of food that is input or output, and the like, through a smartphone. The security camera 5700 may provide an ultrahigh resolution image and may recognize an object or a person in an image in a dark environment by using high sensitivity. The robot 5800 may be provided in a disaster or industrial site that is not directly accessible by people, and may provide a high resolution image. The medical camera 5900 may provide a high resolution image for diagnosis or surgery, and thus a field of vision may be dynamically adjusted.

Furthermore, the image sensor 1000 may be applied to a vehicle 6000 as illustrated in (e) of FIG. 24. The vehicle 6000 may include a plurality of vehicle cameras 6010, 6020, 6030, and 6040 arranged at various positions. Each of the vehicle cameras 6010, 6020, 6030, and 6040 may include an image sensor according to an embodiment. The vehicle 6000 may provide a driver with various pieces of information about the inside or periphery of the vehicle 6000, by using the vehicle cameras 6010, 6020, 6030, and 6040, and thus an object or a person in an image may be automatically recognized and information needed for autonomous driving is provided.

According to the example embodiments described above, the cavities and lower pattern films may be manufactured in a same thickness by forming the cavities and lower pattern films in a periodical pattern by using dielectric materials having different refractive indexes, and by doing so, a manufacturing process of the spectral filter may be simplified. In addition, the manufacturing process may be further simplified by forming the first and second metal reflective layer from one metal material.

By applying a spacer to some of the unit filters and using a center wavelength in the secondary mode as a center wavelength of the resonator, a spectral filter capable of effectively implementing center wavelengths in a wide range without an additional filter such as a color filter may be manufactured.

## Claims

1. A spectral filter comprising:
a first metal reflective layer;
a second metal reflective layer provided above the first metal reflective layer;
a plurality of cavities provided between the first metal reflective layer and the second metal reflective layer, the plurality of cavities comprising first patterns respectively corresponding to different center wavelengths; and
a plurality of lower pattern films provided below the first metal reflective layer, the plurality of lower pattern films comprising second patterns respectively corresponding to the different center wavelengths.

2. The spectral filter of claim 1, wherein the plurality of cavities have a same thickness and the plurality of lower pattern films have a same thickness,
in particular,
wherein each of the plurality of cavities has a thickness of from about 50 nm to about 400 nm, and/or
wherein each of the plurality of lower pattern films has a thickness of from about 100 nm to about 1,000 nm.

3. The spectral filter of any of the preceding claims, further comprising a spacer provided between at least one of the plurality of cavities and the second metal reflective layer, the spacer comprising a dielectric material,
in particular,
wherein the spacer has a thickness of from about 20 nm to about 300 nm, and/or
wherein the spectral filter further comprises a planarization layer provided on the second metal reflective layer on which the spacer is not provided.

4. The spectral filter of any of the preceding claims, wherein each of the plurality of cavities comprises: a first dielectric material; and a second dielectric material having a refractive index different from that of the first dielectric material, the first dielectric material and the second dielectric material forming a first pattern, and/or
wherein each of the plurality of lower pattern films comprises: a third dielectric material; and a fourth dielectric material having a refractive index different from that of the third dielectric material, the third dielectric material and the fourth dielectric material forming a second pattern,
in particular,
wherein each of the plurality of cavities and/or each of the plurality of lower pattern films further comprises an etch stop layer.

5. The spectral filter of any of the preceding claims, wherein the first metal reflective layer and the second metal reflective layer comprise a same metal material,
in particular,
wherein each of the first metal reflective layer and the second metal reflective layer comprises Al, Ag, Au, Cu, Ti, W, or TiN, and/or
wherein at least one of the first metal reflective layer and the second metal reflective layer further comprises poly-Si.

6. The spectral filter of any of the preceding claims, wherein the first metal reflective layer and the second metal reflective layer has a thickness from about 10 nm to about 80 nm.

7. The spectral filter of any of the preceding claims, further comprising a plurality of upper films provided on the second metal reflective layer, the plurality of upper films having different thicknesses respectively corresponding to the different center wavelengths.

8. The spectral filter of any of the preceding claims, further comprising a plurality of upper pattern films provided on the second metal reflective layer, the plurality of upper pattern films comprising third patterns corresponding to the different center wavelengths,
in particular,
wherein each of the plurality of upper pattern films has a thickness of from about 100 nm to about 1,000 nm, and/or
wherein each of the plurality of upper pattern films further comprises an etch stop layer, and/or
wherein each of the plurality of upper pattern films comprises: a fifth dielectric material; and a sixth dielectric material having a refractive index different from that of the fifth dielectric material, the fifth dielectric material and the sixth dielectric material forming a third pattern.

9. The spectral filter of any of the preceding claims, further comprising a plurality of microlenses or a plurality of nanopatterns provided above the second metal reflective layer.

10. The spectral filter of any of the preceding claims, further comprising an additional filter provided above the second metal reflective layer and only transmitting light of a certain wavelength band,
in particular,
wherein the additional filter comprises a color filter or a broadband filter.

11. The spectral filter of claim any of the preceding claims, further comprising a short wavelength absorption filter provided in a portion of the second metal reflective layer and a long wavelength cut-off filter provided in another portion of the second metal reflective layer.

12. An image sensor comprising:
a pixel array comprising a plurality of pixels; and
a spectral filter according to any of the preceding claims arranged in the pixel array.

13. The image sensor of claim 12, wherein the pixel array comprises a plurality of pixels, and each of the plurality of pixels comprises a wiring layer, in which a driving circuit is provided, and a photodiode provided in the wiring layer.

14. The image sensor of claim 12 or 13, further comprising a timing controller, a row decoder, and an output circuit.

15. An electronic device comprising an image sensor according to any of claims 12 to 14,
in particular,
wherein the electronic device comprises at least one of a mobile phone, a smartphone, a tablet, a smart tablet, a digital camera, a camcorder, a notebook computer, a television, a smart television, a smart refrigerator, a security camera, or a medical camera.
